# EUROPEAN PATENT APPLICATION

(11) **EP 1 881 710 A1**
(43) Date of publication of application: **23.01.2008**
(21) Application number: 07109935.2
(22) Date of filing: 08.06.2007
(51) Int. Cl.: H04N 17/04

(54) **Apparatus and method for inspection of electronic devices**

(30) Priority: 19.07.2006 KR 20060067678
(71) Applicant: SAMSUNG ELECTRONICS CO., LTD., Suwon-si Gyeonggi-do 442-742 (KR)
(72) Inventor: Son, Tae-yong, Suwon-si Gyeonggi-do (KR)
(74) Representative: Robinson, Ian Michael

(57) **Abstract**

Disclosed is an apparatus and method for inspection of an electronic device, which can increase the efficiency of inspection by performing a self inspection. According to an aspect of an exemplary embodiment of the present invention, an electronic device is provided with circuit units (22, 24, 26), comprising an interface unit (40) for interfacing with an external storing apparatus (200); a user setting unit (32, 34) for performing a self inspection; and a controller (50) for controlling each circuit unit (22, 24, 26) to receive a preset control signal, and for controlling the interface unit (40) to store a responding signal corresponding to the control signal outputted from the respective circuit unit (22, 24, 26) in the external storing apparatus (200) if a first function to perform the self inspection is selected through the user setting unit (32, 34).

## Description

The present invention relates to an apparatus and method for the inspection of electronic devices. More particularly, the present invention relates to an apparatus and method for inspecting whether the circuit units of an electronic device are functioning properly.

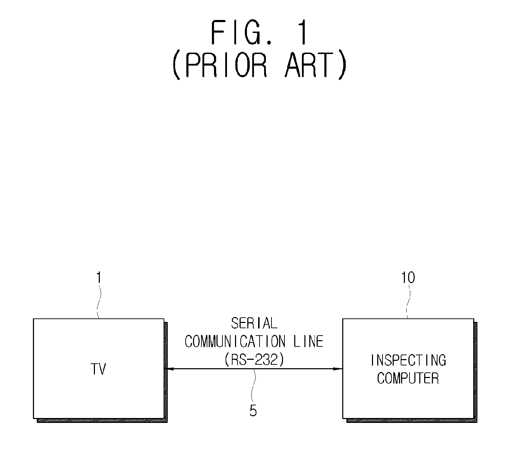

Figure 1 is a block diagram illustrating the conventional inspection system for an electronic device.

As illustrated, the conventional inspection system for an electronic device includes a TV 1 as the object of inspection, an inspecting computer 10, and a serial communication line 5 to connect the TV 1 to the inspecting computer 10.

Here, a display device such as a digital set-top box or a TV may be the object of inspection. For example, Figure 1 provides that the object of inspection is a TV 1. Further, the serial communication line 5 is an RS-232 cable, by way of example.

Conventionally, as illustrated in Figure 1, the inspecting computer 10 is connected to the TV 1 through the RS-232 cable 5 to inspect the operation of the TV 1. At this time, the inspecting computer 10 executes a hyper terminal to inspect the operation of the TV 1. Here, the hyper terminal is a program executed on the general operating system of a computer.

In particular, if the inspecting computer 10 executes the hyper terminal to output a predetermined control signal such as a channel up or down control signal or a volume up or down control signal to the TV 1, the TV 1 performs an operation corresponding to the predetermined control signal, and outputs a corresponding responding signal to the inspecting computer 10. Accordingly, the inspecting computer 10 can inspect whether the TV 1 is functioning properly by checking the responding signal.

However, if the electronic device, in this case a TV 1, is under a production line or if a user requests a service engineer to visit his or her home to inspect the operation or defects of the electronic device, the service engineer would be required to take along the above-described RS-232 cable 5 as well as the inspecting computer 10 to inspect the electronic device, thereby lowering the efficiency of the inspection.

Accordingly, there is a need for an improved efficiency of inspection wherein the service engineer can conveniently take an external storing apparatus, which can be easily carried to an inspecting computer, and simply confirm the test results from the inspection of the electronic device by controlling the electronic device to perform the self inspection for itself and storing the responding signal in the external storing apparatus without having to carry along the inspecting computer and an RS-232 cable.

According to the present invention there is provided an apparatus and method as set forth in the appended claims. Preferred features of the invention will be apparent from the dependent claims, and the description which follows.

Exemplary embodiments of the present invention address at least the above problems and/or disadvantages and provide at least the advantages described below. Accordingly, it is an aspect of an exemplary embodiment of the present invention to provide an apparatus and method for inspection of an electronic device, which can increase the efficiency of inspection by briefly performing a self inspection.

According to an aspect of an exemplary embodiment of the present invention, an electronic device is provided with circuit units, comprising: an interface unit for interfacing with an external storing apparatus; a user setting unit for performing a self inspection; and a controller for controlling each circuit unit to receive a preset control signal, and for controlling the interface unit to store a responding signal corresponding to the control signal outputted from the respective circuit unit in the external storing apparatus if a first function to perform the self inspection is selected through the user setting unit.

According to another aspect of an exemplary embodiment of the present invention, the electronic device further comprises a memory for storing the control signal, wherein the controller controls the respective circuit units for receiving the preset control signal stored in the memory.

According to another aspect of an exemplary embodiment of the present invention, the controller controls a circuit unit preset as the object of the self inspection among the circuit units for receiving the preset control signal if the first function to perform the self inspection is selected through the user setting unit.

According to another aspect of an exemplary embodiment of the present invention, the user setting unit comprises a user input unit for receiving a user input, and a UI generating unit for generating a self inspection function menu including a first menu item to perform the self inspection among circuit units.

According to another aspect of an exemplary embodiment of the present invention, the UI generating unit generates the self inspection function menu further including a second menu item for selecting the circuit unit as the object of the self inspection.

According to another aspect of an exemplary embodiment of the present invention, the controller controls the circuit unit preset as the object of self inspection among the circuit units for receiving the preset control signal if the first menu item for performing the self inspection and the object of the self inspection are selected in the self inspection function menu by the user input through the user input unit.

According to another aspect of an exemplary embodiment of the present invention, the external storing apparatus comprises a USB (Universal Serial Bus) storing apparatus.

According to another aspect of an exemplary embodiment of the present invention, the interface unit comprises a USB connecting unit to be connected to the external storing apparatus, and a USB controller for communicating with the external storing apparatus that is connected to the USB connecting unit.

According to another aspect of an exemplary embodiment of the present invention, the respective circuit units comprise a tuner unit for selecting a broadcast signal, a signal processing unit for processing the selected broadcast signal, the interface unit, and a power controller for outputting a driving power to the tuner unit, the processing unit, and the interface unit.

According to another aspect of an exemplary embodiment of the present invention, the respective circuit units further comprise a display unit for displaying a video corresponding to the broadcast signal processed in the signal processing unit.

According to an aspect of an exemplary embodiment of the present invention, an inspection method is provided for an electronic device including circuit units and an interface unit to interface with an external storing apparatus, comprising: determining whether a first function to perform a self inspection is selected through the user setting unit that selects the first function to perform the self inspection; supplying the respective circuit unit with a preset control signal if the first function to perform the self inspection is selected; and controlling the interface unit to store a responding signal corresponding to the control signal outputted from the respective circuit units in the external storing apparatus.

According to another aspect of an exemplary embodiment of the present invention, supplying the respective circuit units with a preset control signal comprises controlling a circuit unit preset as the object of the self inspection among the circuit units for receiving the preset control signal if the first function to perform the self inspection is selected.

According to another aspect of an exemplary embodiment of the present invention, the user setting unit comprises a user input unit for receiving a user input, and a UI generating unit for generating a self inspection function menu including a first menu item for performing the self inspection.

According to another aspect of an exemplary embodiment of the present invention, supplying the respective circuit unit with the preset control signal comprises supplying the circuit unit preset as the object of self inspection among the circuit units with the preset control signal if the first menu item for performing the self inspection and the object of the self inspection in the self inspection function menu are selected through the user input unit.

According to another aspect of an exemplary embodiment of the present invention, the interface unit comprises a USB connecting unit to be connected to the external storing apparatus, and a USB controller for communicating with the external storing apparatus that is connected to the USB connecting unit.

According to another aspect of an exemplary embodiment of the present invention, the respective circuit units comprise a tuner unit for selecting a broadcast signal, a signal processing unit for processing the selected broadcast signal, the interface unit, and a power controller for outputting a driving power to the tuner unit, the processing unit, and the interface unit.

According to another aspect of an exemplary embodiment of the present invention, the respective circuit units further comprise a display unit for displaying a video corresponding to the broadcast signal processed in the signal processing unit.

According to an aspect of an exemplary embodiment of the present invention, a computer-readable recording medium for inspection of electronic devices comprises: a first set of instructions for determining whether a first function to perform the self inspection is selected through the user setting unit that selects the first function to perform the self inspection; a second set of instructions for supplying the respective circuit unit with a preset control signal if the first function to perform the self inspection is selected; and a third set of instructions for controlling the interface unit to store a responding signal corresponding to the control signal outputted from the respective circuit units in the external storing apparatus.

Other aspects, advantages, and salient features of the invention will become apparent to those skilled in the art from the following detailed description, which, taken in conjunction with the annexed drawings, discloses exemplary embodiments of the invention.

The above and other aspects, features, and advantages of certain embodiments of the present invention will be more apparent from the following description taken in conjunction with the accompanying drawings, in which:
Figure 1 is a block diagram illustrating a conventional inspection system for an electronic device;
Figure 2 is a control block diagram illustrating an inspection system for an electronic device according to an exemplary embodiment of the present invention;
Figure 3 is a flowchart illustrating an inspection method of an electronic device according to an exemplary embodiment of the present invention; and
Figure 4 is an exemplary diagram illustrating a self inspection function menu in the electronic device according to an exemplary embodiment of the present invention.

Throughout the drawings, the same drawing reference numerals will be understood to refer to the same elements, features and structures.

The matters defined in the description such as a detailed construction and elements are provided to assist in a comprehensive understanding of the embodiments of the invention and are merely exemplary. Accordingly, those of ordinary skill in the art will recognize that various changes and modifications of the embodiments described herein can be made without departing from the scope and spirit of the invention. Also, descriptions of well-known functions and constructions are omitted for clarity and conciseness.

Reference will now be made in particular to the exemplary embodiments of the present invention in conjunction with the accompanying drawings.

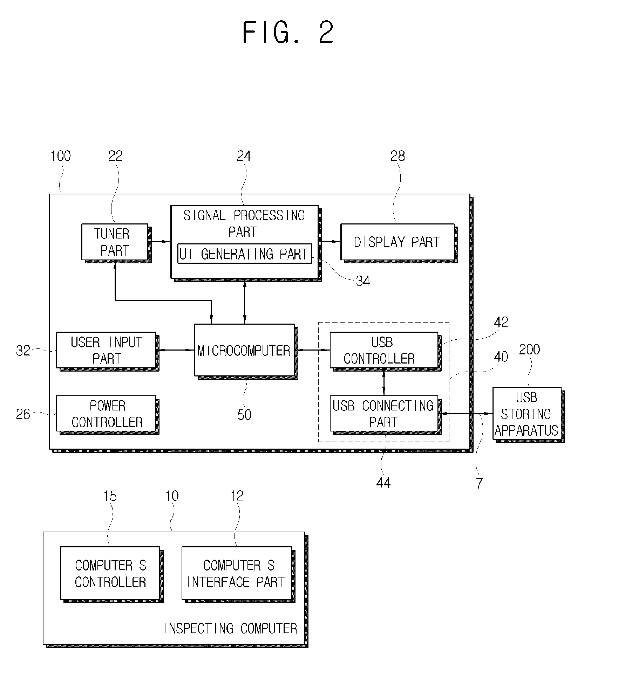

Figure 2 is a control block diagram illustrating an inspection system for an electronic device according to an exemplary embodiment of the present invention. As illustrated, the inspection system for the electronic device according to the an exemplary embodiment of the present invention includes a TV 100, which is the object of the inspection, a USB storing apparatus 200 provided as an external storing apparatus, and a USB cable 7 to connect the USB storing apparatus 200 to the TV 100.

It is noted that a display device such as a digital set-top box, a portable computer, a PDA (Personal Digital Assistant), or the like, may also be the object of inspection. In an exemplary embodiment of the present invention, it is provided that the TV 100 is the electronic device that is the object of the inspection.

As illustrated in Figure 2, the TV 100 includes various circuit units to perform a function of the TV 100; the USB storing apparatus 200; an interface unit 40 to interface with the USB storing apparatus 200; a user setting unit 32 and 34 to perform a self inspection; and a microcomputer 50 to control the respective circuit units to receive a preset control signal, and to control the interface unit 40 to store each responding signal corresponding to the control signal outputted from the respective circuit units in the USB storing apparatus 200, if a function to perform the self inspection is selected through the user setting unit 32 and 34.

The various circuit units perform the function of the TV 100. Herein, illustrated in Figure 2, the circuit units include a tuner unit 22 to select a broadcast signal, a signal processing unit 24 to process the selected broadcast signal, and a power controller 26 to output a driving power to the tuner unit 22, the signal processing unit 24, the interface unit 40, and the user setting unit 32 and 34. Here, in Figure 2, the supplying lines that the power controller uses to supply the driving power to the microcomputer 50, the tuner unit 22, the signal processing unit 40, the user setting unit 32 and 34, and the interface unit 40 are omitted. As described above, a user input unit 32, a UI generating unit 34 and the interface unit 40 are provided as various circuit units. Further, the user input unit 32, the UI generating unit 34, and the interface unit 40 may be selected as the object of inspection.

At this time, the signal processing unit 24 may include an IF (Intermediate Frequency) demodulator, and a video demodulator. In the case that the TV 100 is a digital TV, the TV 100 may include a channel decoder, a TP (Transport Protocol) decoder, and a video decoder. Further, the signal processing unit 24 may be provided to process a broadcast signal according to a configuration of a display unit 28 employing an LCD (Liquid Crystal Display), or a CRT (Cathode Ray Tube) display, for example.

Alternatively, in the case that the electronic device provided as the object of inspection is a digital set-top box, the digital set-top box does not include the display unit 28. Instead, the digital set-top box may include a signal outputting unit to output the broadcast signal processed in the signal processing unit to an external display.

The user setting unit 32 and 34 receives a user input to perform the self inspection. Herein, as illustrated in Figure 2, the user setting unit 32 and 34 may include the user input unit 32 to receive the user input, and the UI generating unit 34 to generate a self inspection function menu to perform the self inspection.

Alternatively, unlike Figure 2, the user setting unit may perform the self inspection without generating the self inspection function menu by receiving a user input through a simple functional key provided thereon.

On the other hand, in the user setting unit 32 and 34, the user input unit 32 is an information input apparatus that receives a key-input from a user. Herein, the user input unit 32 may provided as a plurality of keys at a lower area of the display unit 28 in front of a main body of the TV 100, or as a remote controller to apply a key signal to the TV 100 from a distance.

The UI generating unit 34, according to a control of the microcomputer 50, generates the self inspection function menu to determine whether or not to perform the self inspection. In particular, the UI generating unit 34 generates the self inspection function menu including a self inspection performing menu item (or a first menu item) to perform the self inspection. If it is determined to perform the self inspection, the UI generating unit 34 generates the self inspection function menu, further including an inspection object selecting menu item (or a second menu item) to select the object of self inspection among various circuit units 22, 24, 26, 28, 32, 34, and 40.

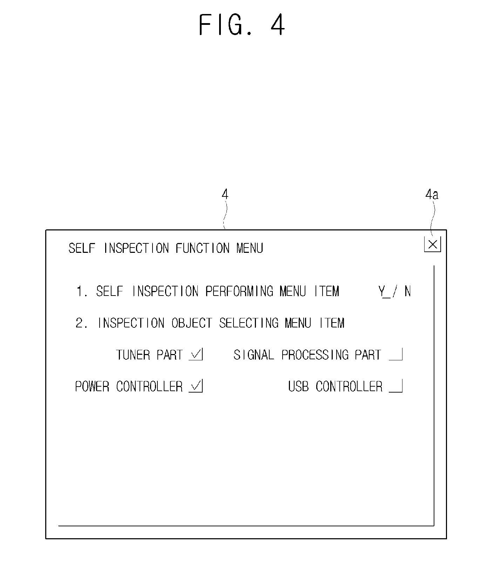

As illustrated in Figure 4, a self inspection function menu screen 4 includes an EXIT item 4a to close the self inspection menu screen 4, a self inspection performing menu item 1 to determine whether to perform the self inspection, and an inspection object selecting menu item 2 to select an object of the self inspection among various circuit units 22, 24, 26, 28, 32, 34, and 40. For example, in the self inspection function menu screen 4, a 'Y' sub item is selected in 'Y' or 'N' sub items for the self inspection performing menu item 1, and a "tuner unit" sub item and a "power controller" sub item are selected among "tuner unit," "signal processing unit," "power controller," "USB controller" sub items for the inspection object selecting menu item 2. Here, if the 'Y' sub item is selected, the self inspection is performed. Further, if the 'N' sub item is selected, the self inspection is not performed.

Referring to Figure 2 again, the interface unit 40 interfaces with the USB storing apparatus 200. Herein, the interface unit 40 includes a USB connecting unit 44 to be connected to the USB storing apparatus 200, and a USB controller 42 to communicate with the USB storing apparatus 200 that is connected to the USB connecting unit 44.

The USB controller 42, according to the control of the microcomputer 50, may generally read out data such as image data or MP3 audio data from the USB storing apparatus 200 that is connected to the USB connecting unit 44. Further, if the self inspection is performed, the USB controller 42 may store a responding signal outputted from the object of the self inspection (for example, the tuner unit 22 and the power controller 26) in the USB storing apparatus 200.

On the other hand, if the function to perform the self inspection is selected through the user setting unit 32 and 34, the microcomputer 50 as a controller controls the respective circuit units 22, 24, 26, 28, 32, 34, and 40 to receive a preset control signal and controls the interface unit 40 to store a responding signal outputted from the respective circuit units 22, 24, 26, 28, 32, 34, and 40 corresponding to the preset control signal.

For example, in Figure 4, if the 'Y' sub item of menu item 1, and the objects of the self inspection (for example, the "tuner unit" sub item and the "power controller" sub item) of menu item 2 are selected from the self inspection function menu screen 4 based on functions of the user input unit 32 and the UI generating unit 34, the microcomputer 50 controls the tuner unit 22 and the power controller 26 preset as the objects of the self inspection among the respective circuit units 22, 24, 26, 28, 32, 34, and 40 to receive the preset control signal.

At this time, if the respective circuit units 22, 24, 26, 28, 32, 34, and 40 are functioning properly, a memory equipped inside or outside of the microcomputer 50 presets control signals corresponding to the respective circuit units 22, 24, 26, 28, 32, 34, and 40, in order to control the respective circuit units 22, 24, 26, 28, 32, 34, and 40 to output reference responding signals. For example, if the self inspection is performed, the microcomputer 50 outputs concerned control signals to the tuner unit 22 and the power controller 26 selected as the objects of the self inspection.

Alternatively, in another exemplary embodiment of the present invention, if a user setting unit performs the self inspection without generating the self inspection function menu screen 4 by receiving user input through a simple functional key provided thereon, or that the self inspection function menu screen 4 does not include the inspection object selecting menu item 2 to select an object of the self inspection, circuit units that frequently need the self inspection (for example, the tuner unit 22, the power controller 26, and the UI generating unit 34), or all circuit units inside of the TV 100 may be preset as the objects of the self inspection in the microcomputer 50.

Accordingly, if the self inspection is performed, the microcomputer 50 can control the preset circuit units (for example, the tuner unit 22, the power controller 26, and the UI generating unit 34) to receive the preset control signal corresponding to the respective preset circuit units.

The respective circuit units (for example, the tuner unit 22 and the power controller 26), which are the objects of the self inspection, receive the preset control signals from the microcomputer 50, perform operations corresponding to the preset control signals, and output corresponding responding signals. Here, the operations may include channel up or down, or going into a power saving mode. Alternatively, the operation may vary according to the preset control signal outputted from the microcomputer 50.

It follows that the microcomputer 50 controls the USB controller 42 to store the responding signal outputted from the circuit units as the object of the self inspection (for example, the tuner unit 22 and the power controller 26) in the USB storing apparatus 200.

Accordingly, if the self inspection is performed, the circuit units that are the objects of the self inspection (for example, the tuner unit 22 and the power controller 26) may perform the operations corresponding to the control signals outputted from the microcomputer 50, and the USB controller 42 may store the corresponding responding signal in the USB storing apparatus 200.

On the other hand, the inspection system for the electronic device according to an exemplary embodiment of the present invention may further include an inspecting computer 10'.

The inspecting computer 10' includes a computer's interface unit 12 to interface with the USB storing apparatus 200, and a computer's controller 15 to determine whether the respective circuit units inside the TV 100 are functioning properly based on the responding signal stored in the USB storing apparatus 200.

The computer's interface unit 12 performs the same function as a general USB interface unit. Herein, the computer's interface unit 12 may includes a USB connecting unit, and a USB controller.

The computer's controller 15 stores reference responding information to output the reference responding signal if the circuit units inside of the TV 100 are functioning properly. Particularly, the computer's controller 15 presets the reference responding information corresponding to the respective circuit units, and receives each responding signal stored in the USB storing apparatus 200 through the computers interface unit 12. Then, the computer's controller 15 determines whether the respective responding signals correspond to the preset reference responding information.

For example, if the responding signals stored in the USB storing apparatus 200 based on the reference responding information of the respective circuit units, (for example, the tuner unit 22 and the power controller 26) correspond to the reference responding information corresponding to the tuner unit 22 and the power controller 26, the computer's controller 15 determines that the tuner unit 22 and the power controller 26 are functioning properly. Conversely, if the responding signals do not correspond to the reference responding information corresponding to the tuner unit 22 and the power controller 26, the computer's controller 15 determines that the tuner unit 22 and the power controller 26 are not functioning properly.

As described above, apparatus and method for inspection of an electronic device according to an exemplary embodiment of the present invention provides a control signal for a self inspection, and stores a responding signal outputted from the respective circuit unit inside the device according to the control signal in the external storing apparatus (described as a USB storing apparatus 200, for example in the above-described embodiment) to interface with the outside storing apparatus.

Accordingly, if a user requests a service engineer to visit his or her home to inspect the operation or defects of the electronic device, the service engineer can conveniently take the external storing apparatus, that can be easily carried to an inspecting computer, and simply confirm the test results from the inspection of the electric apparatus without having to carry along the inspecting computer. By controlling the electronic device to perform the self inspection for itself and storing the responding signal in the external storing apparatus, an exemplary embodiment of the present invention can increase the inspection efficiency by solving the problem of carrying an RS-232 cable and an inspecting computer, both of which are unavoidably necessary in the conventional inspection system for electronic devices.

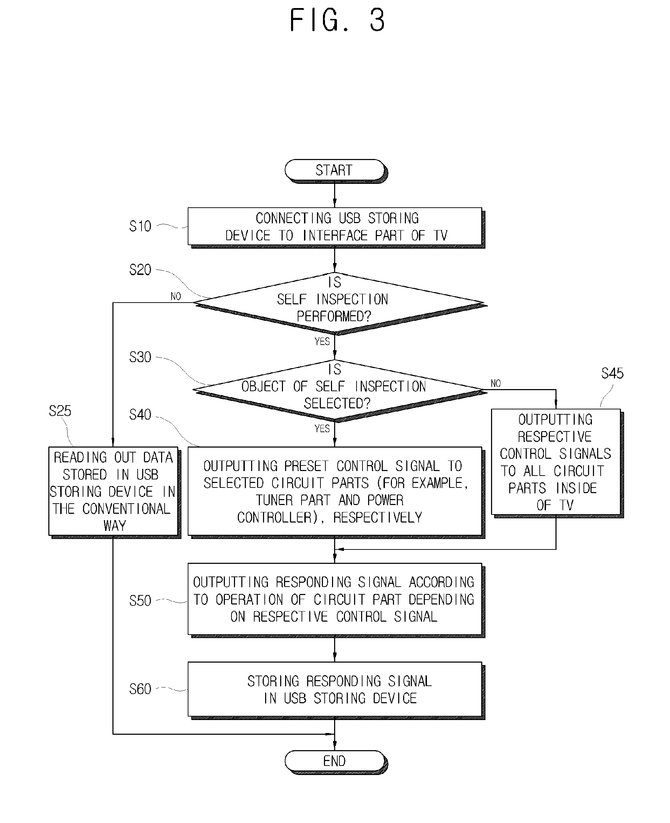

A control method of the TV 100 as an electronic device including the above-described configuration will be hereinafter described with reference to Figure 3.

First, if a user connects the USB storing apparatus 200 to the interface unit 40 of the TV 100 to perform a self inspection (S10), the microcomputer 50 determines whether the self inspection is performed by user manipulation (S20). If the self inspection is determined not to be performed, the interface unit 40 connected to the USB storing apparatus 200 generally will read out data such as image data or MP3 audio data stored in the USB storing apparatus 200 in the conventional way (S25). Conversely, if the self inspection is determined to be performed, the microcomputer 50 further determines whether a circuit unit is selected as an object of the self inspection (S30).

As the result, if a circuit unit is selected as an object of the self inspection, the microcomputer 50 outputs a control signal, which is preset in a memory equipped inside or outside thereof, corresponding to the selected circuit unit (for example, the tuner unit 22 and the power controller 26) to the tuner unit 22 and the power controller 26, respectively (S40). Then, the tuner unit 22 and the power controller 26, respectively perform an operation depending on the preset control signal, and output a responding signal according to the respective operations (S50). The microcomputer 50 controls the USB controller 42 of the interface unit 40 to store the respective responding signals outputted from the tuner unit 22 and the power controller 26 in the USB storing apparatus (S60).

In operation S30, if a circuit unit is not selected as an object of the self inspection, the microcomputer 50 outputs the respective corresponding control signals to preset circuit units (for example, the tuner unit 22, the power controller, and the UI generating unit) or all circuit units inside of the TV 100 (S45). Then, the microcomputer 50 controls the USB controller 42 of the interface unit 40 to store a responding signal according to an operation of corresponding circuit unit depending on the respective control signals in the USB storing apparatus 200 (S50 and S60).

As described above, the apparatus and method for inspection of an electronic device according to an exemplary embodiment of the present invention provides a control signal for the self inspection, and stores a responding signal outputted from a circuit unit inside thereof, which is operated depending on the control signal, to an outside storing apparatus (described as a USB storing apparatus 200, for example in the above-described embodiment).

Accordingly, if a user requests a service engineer to visit him or her to inspect an operation or defects of the electronic device, the service engineer conveniently takes an outside storing apparatus that can be easily carried an inspecting computer instead of the inspecting computer that is more difficult to carry along. Thus, the service engineer can inspect the electric apparatus by controlling the electronic device to perform the self inspection by itself and to store the responding signal to an outside storing apparatus. As apparent from the above description, according to an exemplary embodiment of the present invention, there is provided an apparatus and method for providing the inspection of an electronic device, which can increase the inspection efficiency by briefly performing a self inspection.

An exemplary embodiment of the present invention can also be embodied as computer-readable codes on a computer-readable recording medium. The computer-readable recording medium is any data storage device that can store data which can thereafter be read by a computer system. Examples of the computer-readable recording medium include, but are not limited to, read-only memory (ROM), random-access memory (RAM), CD-ROMs, magnetic tapes, floppy disks, optical data storage devices, and carrier waves (such as data transmission through the Internet via wired or wireless transmission paths). The computer-readable recording medium can also be distributed over network-coupled computer systems so that the computer-readable code is stored and executed in a distributed fashion. Also, functional programs, codes, and code segments for accomplishing the present invention can be easily construed as within the scope of the invention by programmers skilled in the art to which the present invention pertains.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An electronic device provided with circuit units (22, 24, 26), comprising:
an interface unit (40) for interfacing with an external storing apparatus (200);
a user setting unit (32, 34) for performing a self inspection; and
a controller (50) for controlling each circuit unit (22, 24, 26) to receive a preset control signal, and for controlling the interface unit (40) to store a responding signal corresponding to the control signal outputted from the respective circuit unit (22, 24, 26) in the external storing apparatus (200) if a first function to perform the self inspection is selected through the user setting unit (32, 34).

2. The electronic device according to claim 1, further comprising a memory for storing the control signal, wherein the controller (50) controls the respective circuit units (22, 24, 26) to receive the preset control signal stored in the memory.

3. The electronic device according to claim 1, wherein the controller (50) controls a circuit unit (22, 24, 26) preset as the object of the self inspection among the circuit units (22, 24, 26) for receiving the preset control signal if the first function to perform the self inspection is selected through the user setting unit (32, 34).

4. The electronic device according to claim 1, wherein the user setting unit (32, 34) comprises a user input unit (32) for receiving a user input, and a UI generating unit (34) for generating a self inspection function menu including a first menu item to perform the self inspection among circuit units (22, 24, 26).

5. The electronic device according to claim 4, wherein the UI generating unit (34) generates the self inspection function menu further including a second menu item for selecting the circuit unit (22, 24, 26) as the object of the self inspection.

6. The electronic device according to claim 5, wherein the controller (50) controls the circuit unit (22, 24, 26) preset as the object of self inspection among the circuit units (22, 24, 26) for receiving the preset control signal if the first menu item to perform the self inspection and the object of the self inspection are selected in the self inspection function menu by the user input through the user input unit (32).

7. The electronic device according to claim 1, wherein the external storing apparatus (200) comprises a USB (Universal Serial Bus) storing apparatus.

8. The electronic device according to claim 7, wherein the interface unit (40) comprises a USB connecting unit (44) to be connected to the external storing apparatus (200), and a USB controller (42) for communicating with the external storing apparatus (200) that is connected to the USB connecting unit (44).

9. The electronic device according to claim 8, wherein the respective circuit units (22, 24, 26) comprise a tuner unit (22) for selecting a broadcast signal, a signal processing unit (24) for processing the selected broadcast signal, the interface unit (40), and a power controller (26) for outputting a driving power to the tuner unit (22), the processing unit, and the interface unit (40).

10. The electronic device according to claim 9, wherein the respective circuit units (22, 24, 26) further comprise a display unit (28) for displaying a video corresponding to the broadcast signal processed in the signal processing unit (24).

11. An inspection method of an electronic device including circuit units (22, 24, 26) and an interface unit (40) for interfacing with an external storing apparatus (200), comprising:
determining whether a first function to perform the self inspection is selected through the user setting unit (32, 34) that selects the first function to perform the self inspection;
supplying the respective circuit unit (22, 24, 26) with a preset control signal if the first function to perform the self inspection is selected; and
controlling the interface unit (40) to store a responding signal corresponding to the control signal outputted from the respective circuit units (22, 24, 26) in the external storing apparatus (200).

12. The inspection method according to claim 11, wherein the supplying the respective circuit units (22, 24, 26) with a preset control signal comprises controlling a circuit unit (22, 24, 26) preset as the object of the self inspection among the circuit units (22, 24, 26) for receiving the preset control signal if the first function to perform the self inspection is selected.

13. The inspection method according to claim 11, wherein the user setting unit (32, 34) comprises a user input unit (32) for receiving the user input, and a UI generating unit (34) for generating a self inspection function menu including a first menu item for performing the self inspection.

14. The inspection method according to claim 12, wherein the supplying the respective circuit unit (22, 24, 26) with the preset control signal comprises supplying the circuit unit (22, 24, 26) preset as the object of self inspection among the circuit units (22, 24, 26) with the preset control signal if the first menu item for performing the self inspection and the object of the self inspection in the self inspection function menu are selected through the user input unit (32).

15. The inspection method according to claim 11, wherein the interface unit (40) comprises a USB connecting unit (44) to be connected to the external storing apparatus (200), and a USB controller (42) for communicating with the external storing apparatus (200) that is connected to the USB connecting unit (44).

16. The inspection method according to claim 15, wherein the respective circuit units (22, 24, 26) comprise a tuner unit (22) for selecting a broadcast signal, a signal processing unit (24) for processing the selected broadcast signal, the interface unit (40), and a power controller (26) for outputting a driving power to the tuner unit (22), the processing unit, and the interface unit (40).

17. The inspection method according to claim 16, wherein the respective circuit units (22, 24, 26) further comprise a display unit (28) for displaying a video corresponding to the broadcast signal processed in the signal processing unit (24).

18. A computer-readable recording medium for inspection of electronic devices, comprising:
a first set of instructions for determining whether a first function to perform the self inspection is selected through the user setting unit (32, 34) that selects the first function to perform the self inspection;
a second set of instructions for supplying the respective circuit unit (22, 24, 26) with a preset control signal if the first function to perform the self inspection is selected; and
a third set of instructions for controlling the interface unit (40) to store a responding signal corresponding to the control signal outputted from the respective circuit units (22, 24, 26) in the external storing apparatus (200).
